# FASCICULE DE BREVET EUROPEEN

(11) **EP 3 584 620 B1**
(45) Date de publication et mention de la délivrance du brevet: **21.09.2022**
(21) Numéro de dépôt: 19180952.4
(22) Date de dépôt: 18.06.2019
(51) Int. Cl.: G02B 7/02, G03B 17/55, H04N 5/225

(54) **DISPOSITIF OPTIQUE POUR VEHICULE COMPRENANT UN ELEMENT DE CHAUFFAGE**
OPTISCHE VORRICHTUNG FÜR FAHRZEUG, DIE MIT EINEM HEIZELEMENT AUSGESTATTET IST
OPTICAL DEVICE FOR VEHICLE COMPRISING A HEATING ELEMENT

(30) Priorité: 18.06.2018 FR 1855336
(43) Date de publication de la demande: 25.12.2019
(73) Titulaire: Aptiv Technologies Limited, St. Michael (BB)
(72) Inventeur: Arkadiusz, RAFALOWSKI, 32-064 Brzezinka (PL); Witold, POREDA, 12-221 Ruciane Nida (PL)
(74) Mandataire: Vigand, Philippe

(56) Documents cités:
- EP-A1- 3 153 922
- EP-A1- 3 410 199
- WO-A1-2017/208981

## Description

### DOMAINE TECHNIQUE

La présente invention concerne un dispositif optique pour véhicule et plus particulièrement un dispositif optique comprenant un élément de chauffage.

### ARRIERE-PLAN TECHNOLOGIQUE DE L'INVENTION

Les organes électroniques pour véhicule automobile et agencés à l'extérieur des véhicules doivent subir les contraintes environnementales telles que le froid et la glace. Afin de ne pas subir les effets persistant de ces contraintes, ces organes électroniques sont généralement équipés dispositifs électriques permettant de se débarrasser des effets de ces contraintes. On peut par exemple trouver des organes électroniques munis de dispositifs électriques tels que par exemple des éléments chauffant pour combattre le gel.

Le pilotage de ces dispositifs électriques est généralement réalisé par le biais de faisceaux électriques et de connecteurs reliant une carte de contrôle électronique et les dispositifs électriques.

Les solutions actuelles de raccordement électrique de ces dispositifs électriques sont encombrantes, couteuses et lourdes.

Les documents EP3153922A1 et WO2017/208981A1 divulguent des dispositifs optiques comprenant des cartes à circuit imprimé.

Il est donc important de proposer une solution nouvelle résolvant ces problèmes.

### RESUME DE L'INVENTION

Selon l'invention, un dispositif optique comprend une carte à circuit imprimé comprenant une partie principale rigide et comprenant au moins une partie flexible agencée en périphérie de la partie principale rigide, la partie principale rigide comportant un circuit électronique de capture d'image ; un support de lentilles comprenant au moins une lentille optique, le support de lentilles comprenant une paroi formant une cavité s'étendant selon l'axe optique du dispositif depuis son extrémité haute jusqu'à son extrémité basse, l'extrémité basse étant montée sur la partie principale rigide de la carte à circuit imprimé de sorte à aligner, selon l'axe optique du dispositif, le circuit électronique de capture d'images et la lentille optique; au moins un élément de chauffage agencé sur la partie flexible de la carte à circuit imprimé, la partie flexible de la carte à circuit imprimé étant agencée en appui direct contre la paroi du support de lentilles.

L'extrémité haute de la paroi du support de lentille comprend un rebord orienté vers l'extérieure de la paroi du support de lentilles formant une surface d'appui plane, la partie flexible de la carte à circuit imprimé étant agencée en appui uniquement contre la surface d'appui plane de la paroi du support de lentilles. L'élément de chauffage peut être agencé en appui direct sur la paroi du support de lentilles. Un collier métallique de serrage peut être agencé autour de la paroi du support de lentilles de sorte que chaque partie flexible de la carte à circuit imprimé est pincé entre le collier métallique et la paroi. Chaque partie flexible de la carte à circuit imprimé peut être pincée entre la paroi du support de lentilles et une paroi d'un boîtier de protection du dispositif optique. L'élément de chauffage peut être un motif de trace conductrice de la partie flexible de la carte à circuit imprimé.

La partie flexible de la carte à circuit imprimé peut comprendre une section de chauffage et une section intermédiaire comprise entre la section de chauffage et la partie principale rigide de la carte à circuit imprimé, la section intermédiaire comprenant une partie amincie du substrat de la partie principale rigide de la carte à circuit imprimé, la section de chauffage comprenant l'élément de chauffage. Chaque côté de la partie principale rigide de la carte à circuit imprimé peut être en continuité avec une partie flexible comportant un élément de chauffage.

Selon l'invention, une méthode d'assemblage du dispositif optique décrit ci-dessus comporte les étapes suivantes :
fourniture d'une carte à circuit imprimé comprenant une partie principale rigide comportant un composant électronique de capture d'image, et au moins une partie flexible comportant un élément de chauffage et s'étendant globalement dans le plan de la partie principale rigide;
agencement de la partie principale rigide de la carte à circuit imprimé sur un support de lentilles comportant au moins une lentille optique et comprenant une paroi formant une cavité s'étendant selon l'axe optique du dispositif de sorte à aligner, selon l'axe optique du dispositif, le circuit électronique de capture d'images et la lentille optique ;
pliage de la partie flexible de la carte à circuit imprimé jusqu'à la mise en buté de la partie flexible sur la paroi du support de lentilles ;
fixation de la partie flexible de la carte à circuit imprimé en appui contre la paroi du support de lentilles.
l'étape de pliage et l'étape de fixation peuvent se faire soit par insertion du support de lentilles dans un boîtier de protection du dispositif optique de sorte à venir pincer la partie flexible entre la paroi du boîtier de protection et la paroi du support de lentilles, ou soit par insertion d'un collier de serrage autour de la paroi du support de lentilles et de la partie flexible de sorte à venir pincer la partie flexible entre le collier de serrage et la paroi du support de lentilles.

D'autres buts et avantages de la présente invention apparaîtront au vu de la description qui suit.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique en perspective du dispositif optique selon l'invention.
- La figure 2 est une vue schématique en perspective éclatée du dispositif optique de la figure 1.
- La figure 3 est une vue schématique partielle en perspective en coupe transversale du dispositif optique de la figure 1 illustrant l'élément de chauffage agencé sur le support de lentille.
- Les figures 4, 5, 6, 7, 8 et 9 sont des vues schématiques en perspectives de six étapes d'assemblage du dispositif optique selon l'invention.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », «haut », « dessus », « dessous », « inférieure » et « supérieure » sont définies selon la direction verticale. Des orientations « gauche », « droite » et « latérale » sont définies selon la direction transversale. Des orientations « avant » et « arrière » sont également définies selon la direction longitudinale.

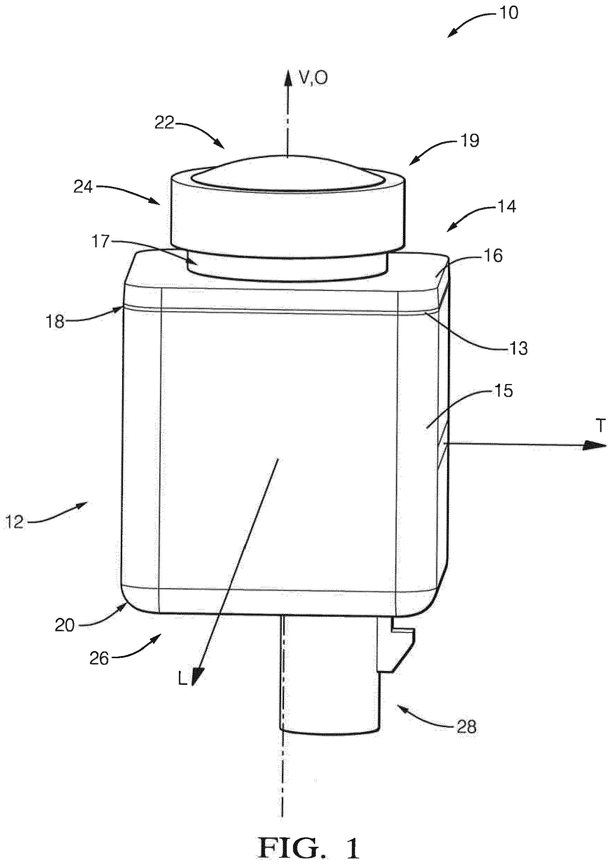

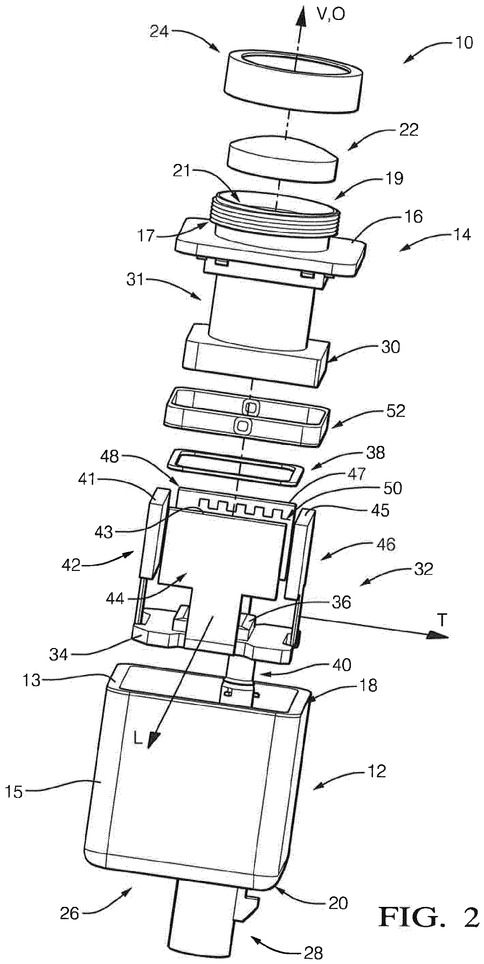

Selon la figure 1 et la figure 2, un dispositif optique 10, plus particulièrement une caméra pour véhicule est représentée. Ce type de caméra est prévu pour être monté à l'extérieur du véhicule et donc subir les conditions extérieures au véhicule tel que le climat.

Selon la figure 1, le dispositif optique 10 comprend un boîtier de protection 12 comprenant une paroi 15 de forme globalement cylindrique s'étendant selon l'axe vertical V depuis son extrémité haute 18 jusqu'à son extrémité basse 20. L'extrémité basse 20 du boîtier de protection 12 est fermée par un fond de boîtier 26. Le fond de boîtier 26 comprend un corps de connecteur 28 s'étendant verticalement vers l'extérieur du boîtier de protection 12, le corps de connecteur 28 étant venu de matière avec le fond de boîtier 26.

Le dispositif optique 10 comprend un support de lentilles 14 s'étendant verticalement dans le boîtier de protection 12. Le support de lentilles 14 est une structure creuse ouverte formant une cavité 21 s'étendant depuis son extrémité haute 19 agencée en dehors du boîtier de protection 12 jusqu'à son extrémité basse 30 insérée dans le boîtier de protection 12. L'extrémité haute 19 du support de lentilles 14 comporte une lentille optique 22 alignée selon l'axe optique O du dispositif optique 10.

Le support de lentilles 14 est maintenu en butée contre l'extrémité haute 18 du boitier de protection 12. Le support de lentilles 14 comprend donc une plaque d'appui 16 agencée en butée contre l'extrémité haute 18 du boîtier de protection 12. Le support de lentilles 14 est fixé en appui contre l'extrémité haute 18 du boîtier de protection 12 par l'intermédiaire d'un premier joint adhésif 13 de sorte à fermer hermétiquement le boîtier de protection 12. La plaque d'appui 16 comprend une ouverture circulaire débouchant sur la cavité 21 du support de lentilles 14 et comportant une paroi supérieure 17 au boîtier de protection 12 s'étendant verticalement jusqu'à l'extrémité haute 19 du support de lentilles 14. La lentille optique 22 vient s'agencer contre la surface interne de la paroi supérieure 17 et est maintenue alignée selon l'axe optique O du dispositif optique 10 par un capot de maintien 24 fixé sur la paroi supérieure 17.

Selon la figure 2, le support de lentille comprend la paroi supérieure 17 agencée par-dessus la plaque d'appui 16 et comprend une paroi inférieure 31 au boîtier de protection 12 s'étendant verticalement depuis la plaque d'appui 16 jusqu'à son extrémité basse 30. L'extrémité basse 30 forme une base de forme globalement parallélépipédique.

Le dispositif optique 10 comprend une carte à circuit imprimé 32 comportant une partie principale rigide 34.

La partie principale rigide 34 est de forme globalement rectangulaire. La partie principale rigide 34 comprend sur sa face supérieure un circuit électronique de capture d'images 36 aligné avec la lentille optique 22 selon l'axe optique O du dispositif optique 10. La partie principale rigide 34 est prévue pour être fixée sur l'extrémité basse 30 du support de lentilles 14 par l'intermédiaire d'un second joint adhésif 38, de sorte à fermer hermétiquement la cavité 21 du support de lentille 14. La partie principale rigide 34 comprend également sur sa face inférieure des terminaux électriques 40 s'étendant verticalement et prévus pour être insérés dans le corps du connecteur 28. La partie principale rigide 34 est donc prévue pour être en fond de boîtier 26 de sorte que ses terminaux électriques 40 puissent être agencés dans le corps du connecteur 28.

La carte à circuit imprimé 32 comprend également quatre parties flexibles 42, 44, 46, 48 agencées en périphérie de la partie principale rigide 34. Plus particulièrement chaque côté de la partie principale rigide 34 est prolongé en continuité de matière par une partie flexible 42, 44, 46, 48. Chaque partie flexible 42, 44, 46, 48 est pliée verticalement vers le haut de sorte à venir en appui sur la paroi inférieure 31 du support de lentilles 14.

Afin de maintenir les parties flexibles 42, 44, 46, 48 en appui sur la paroi inférieure 31 du support de lentilles 14, un collier de serrage 52 est configuré pour être agencé autour des parties flexibles 42, 44, 46, 48 de sorte à comprimer et pincer les parties flexibles 42, 44, 46, 48 entre la paroi inférieure 31 du support de lentilles 14 et le collier de serrage 52.

De façon alternative, le maintien des parties flexibles 42, 44, 46, 48 en appui contre la paroi inférieure 31 du support de lentilles 14 peut être réalisé par la face interne de la paroi 15 cylindrique du boîtier de protection 12, la paroi 15 cylindrique permettant de comprimer et pincer les parties flexibles 42, 44, 46, 48 entre la paroi inférieure 31 du support de lentilles 14 et la face interne de la paroi 15 cylindrique du boîtier de protection 12.

Chaque partie flexible 42, 44, 46, 48 comprend des moyens de chauffage 50 configurés pour chauffer la paroi inférieure 31 du support de lentilles 14. Afin d'optimiser le transfert de chaleur vers le support de lentilles 14, les moyens de chauffage 50 sont également agencés en appui contre la paroi inférieure 31 du support de lentilles 14. La diffusion de la chaleur au travers du support de lentilles 14 permet, lorsque nécessaire de désembuer et/ou dégivrer la ou les lentilles 22 agencées sur le support de lentilles 14.

Puisque la lentille 22 la plus exposée aux conditions climatiques est la lentille 22 agencée à l'extrémité haute 19 du support de lentilles 14, de préférence les moyens de chauffage 50 sont agencés à l'extrémité libre 41, 43, 45, 47 selon la direction vertical de chaque partie flexible 42, 44, 46, 48, au plus proche de la plaque d'appui 16 du support de lentilles 14.

Les moyens de chauffage 50 peuvent être des éléments électriques résistifs agencés sur les parties flexibles 42, 44, 46, 48 de la carte à circuit imprimé 32. Les éléments électriques résistifs peuvent par exemple être des motifs résistifs comprenant des traces conductrices électriques, telle que des pistes conductrices de cuivres, les traces électriques étant tracées en forme de créneaux de sorte à maximiser la chaleur produite par un courant électrique traversant les traces électriques.

De manière non limitative, le courant électrique peut être produit par un circuit de commande de dégivrage de la lentille 22 agencé hors de la caméra. Le courant électrique peut circuler dans chaque partie flexible 42, 44, 46, 48, via les terminaux électriques 40 de la partie principale rigide 34.

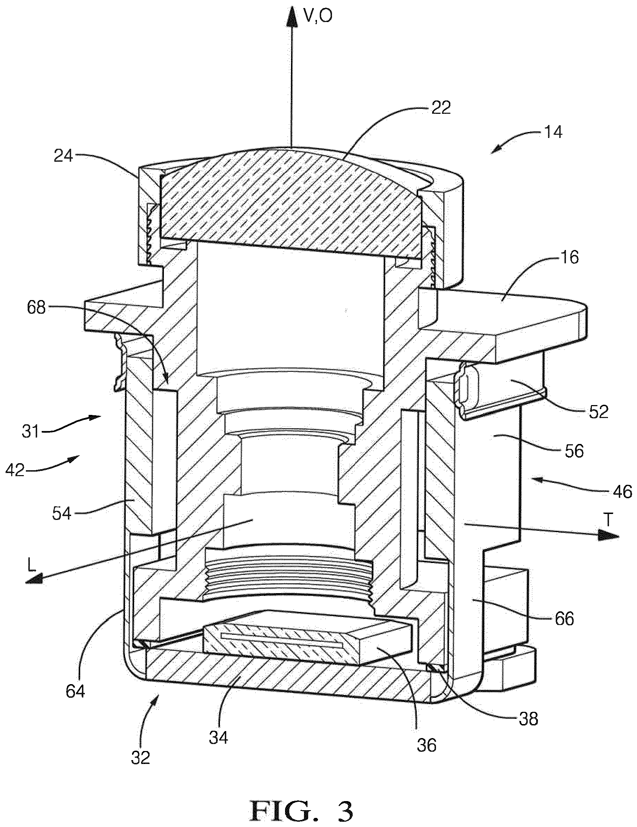

Selon la figure 3, les parties flexibles 42, 44, 46, 48 de la carte à circuit imprimé 32 comprennent chacune une section de chauffage 54, 56 et une section intermédiaire 64, 66 comprise entre la section de chauffage 54, 56 et la partie principale rigide 34 de la carte à circuit imprimé 32. Chaque section intermédiaire 64, 66 est formée par une partie amincie du substrat de la partie principale rigide 34 de la carte à circuit imprimé 32. Chaque section de chauffage 54, 56 est généralement d'épaisseur de substrat similaire de la partie principale rigide 34 de la carte à circuit imprimé 32.

De façon générale, chaque partie intermédiaire 64, 66 comprend des connexions électriques permettant d'alimenter les éléments de chauffage 50 agencé sur chaque section de chauffage 54, 56 de chaque partie flexible 54, 56.

Le collier de serrage 52 est agencé autour des sections de chauffage 54, 56 et est également agencé au contact de la plaque d'appui 16 du support de lentilles 14. En d'autres termes, le collier de serrage 52 est agencé autour des extrémités libres 41, 43, 45, 47 selon la direction vertical des sections de chauffage 54, 56 et vient également former un conduit thermique de chaque section de chauffage 54, 56 vers la plaque d'appui 16 du support de lentilles 14.

Egalement, l'extrémité haute de la paroi inférieure 31 du support de lentilles 14 comprend un rebord 68 orienté vers l'extérieure de la paroi inférieure 31 formant une surface plane d'appui, chaque section de chauffage 54, 56 étant agencée en appui uniquement contre la surface plane d'appui de la paroi inférieure 31.

Ainsi, la diffusion de chaleur vers la lentille 22 optique agencée sur l'extrémité haute 19 du support de lentilles 14 est optimisée. Un collier de serrage 52 métallique permet d'optimiser au mieux la dissipation de chaleur vers le support de lentilles 14 et donc vers la lentille optique 22. Un support de lentilles 14 métallique permet également une diffusion de la chaleur optimale vers la lentille optique 15.

Bien que le mode de réalisation représenté par les figures 1, 2 et 3 comprenne quatre parties flexibles 42, 44, 46, 48, il suffit d'au moins une partie flexible 42 comprenant un moyen de chauffage 50, et agencée en appui au contact de la paroi inférieure 31 du support de lentilles 14 pour permettre de diffuser de la chaleur vers la lentille optique 22. Néanmoins, l'utilisation de quatre parties flexibles 42, 44, 46, 48 permet d'obtenir une chaleur plus élevée et une meilleure répartition de la chaleur autour du support de lentilles 14.

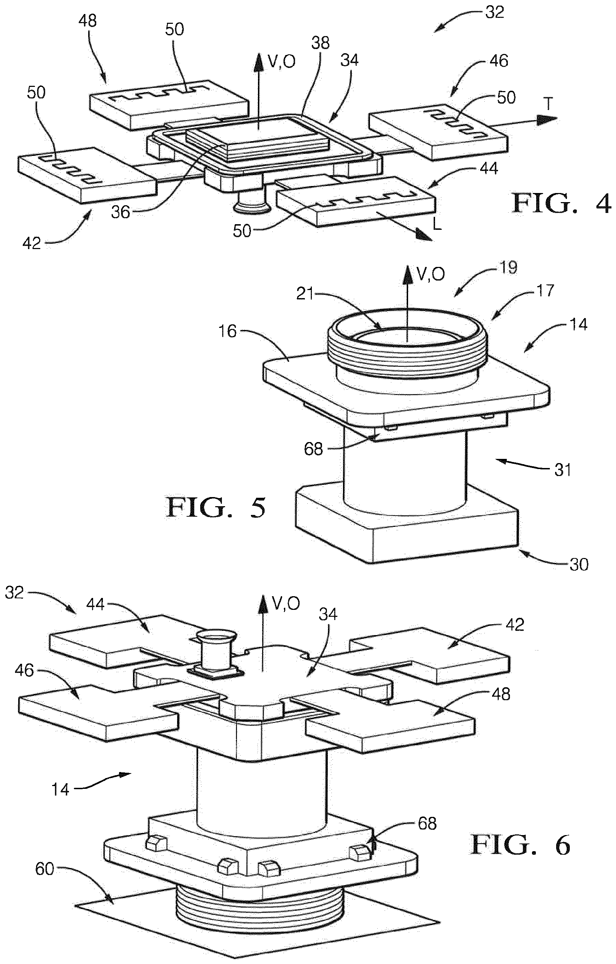

Selon les figures 4, 5, 6, 7, 8 et 9 six étapes d'assemblage du dispositif optique 10 sont représentées.

Selon la figure 4, une première étape consiste à la fourniture de la carte à circuit imprimé 32 comportant le composant électronique de capture d'image 32. Plus particulièrement, la carte à circuit imprimé 32 comprend la partie principale rigide 34 comportant le composant électronique de capture d'image 36, et les quatre parties flexibles 42, 44, 46, 48 comportant chacun un élément de chauffage 50. Avant l'assemblage du dispositif optique 10, les quatre parties flexibles 42, 44, 46, 48 s'étendent globalement dans le plan de la partie principale rigide 34. Le second joint adhésif 38 peut être pré-assemblé sur la partie principale rigide 34.

Selon la figure 5, une étape consiste à la fourniture du support de lentilles 14. Le support de lentilles 14 comprend une paroi verticale formant la cavité 21 du support de lentille. L'extrémité basse 30 du support de lentilles 14 est prévue pour être assemblé sur la partie rigide principale 34 de la carte à circuit imprimé 32, l'extrémité haute 19 du support de lentilles 14 étant configurée pour recevoir la lentille optique 22 de sorte que la lentille optique 22 soit alignée selon l'axe optique O du dispositif optique 10 avec le composant électronique de capture d'image 36. Selon le mode de réalisation particulier représenté, la paroi verticale du support de lentilles 14 comprend la plaque de butée 16 agencée transversalement au support de lentilles 14 et comprenant l'ouverture circulaire agencée autour de la cavité du support de lentilles 14. La plaque de butée 16 partage la paroi du support de lentilles 14 de part et d'autre de la plaque de butée 16. La paroi inférieure 31 verticale agencée sous la plaque de butée 16 est prévue pour être insérée dans le boîtier de protection 12 du dispositif optique 10. La paroi supérieure 17 verticale agencée par-dessus la plaque de butée 16 est prévue pour être agencée à l'extérieure du boîtier de protection 12. L'extrémité haute 19 de la paroi extérieure 17 peut notamment comprendre un filetage afin de venir fixer par vissage le capot de maintien 24 de la lentille optique 22.

Selon la figure 6, une première étape d'assemblage de la carte à circuit imprimé 32 avec le support de lentilles 14 est représentée. Le support de lentilles 14 est positionné retourné de sorte que son extrémité haute 19 est disposée en appui sur un socle 60, l'extrémité basse 30 du support de lentilles 14 étant orientée vers le haut selon l'axe vertical V.

La partie rigide principale 34 de la carte à circuit imprimé 32 est fixé en appui contre l'extrémité basse 30 du support de lentilles 14, le composant électronique de capture d'images 36 étant orienté vers l'intérieur de la cavité 21 du support de lentilles 14. De préférence, l'alignement selon l'axe optique O du dispositif optique 10 du composant électronique de capture d'images 36 et la lentille optique 22 s'effectue avant que le second joint adhésif 38 fixe définitivement la partie principale rigide 34 de la carte à circuit imprimé 32 sur l'extrémité basse 30 du support de lentilles 14. A cette étape, il faut noter que les quatre parties flexibles 42, 44, 46, 48 de la carte à circuit imprimé 32 comportant chacun un élément de chauffage 50 s'étendent encore globalement dans le plan de la partie principale rigide 34. En effet, la structure de ce type de carte à circuit imprimé 32 communément appelé circuit imprimé flex-rigide, nécessite l'application d'une force F sur les parties flexibles 42, 44, 46, 48 de sorte à les plier suivant un angle de pliage voulu avec la partie principale rigide 34.

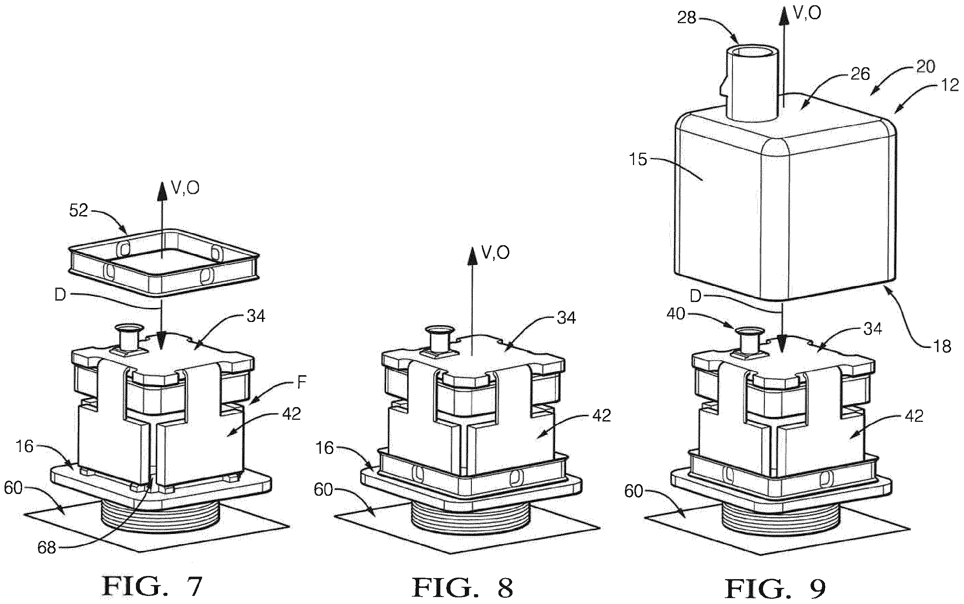

Selon la figure 7, une étape de pliage des partie flexibles 42, 44, 46, 48 est illustrée. Afin de réaliser cette étape de pliage, le support de lentilles 14 est toujours maintenu avec son extrémité haute 19 disposée en appui sur le socle 60. Une force d'appui F a été exercée sur les parties flexibles 42, 44, 46, 48 de sorte à les positionner en appui contre la paroi 31 du support de lentilles 14. Afin de maintenir fixement les parties flexibles 42, 44, 46, 48 contre la paroi 31 du support de lentilles 14, le collier de serrage 52 est inséré suivant la direction D vertical autour des parties flexibles 42, 44, 46, 48.

Selon la figure 8, le collier de serrage 52 est inséré autour des parties flexibles 42, 44, 46, 48 jusqu'à venir en butée contre la plaque d'appui 16 du support de lentilles 14. Le collier de serrage 52 peut être ajusté pour comprimer et pincer les parties flexibles 42, 44, 46, 48 entre le collier de serrage 52 et la paroi 31 du support de lentilles 14.

De façon optimale, l'étape de pliage et l'étape d'insertion du collier de serrage 52 autour des parties flexibles 42, 44, 46, 48, peuvent être combinées de sorte que c'est l'insertion du collier de serrage 52 suivant la direction verticale D qui provoque le pliage des parties flexibles 42, 44, 46, 48, le collier de serrage 52 étant préalablement agencé sur les parties flexibles 42, 44, 46, 48 lorsque celles-ci s'étendent encore globalement dans le plan de la partie principale rigide 34 comme illustré sur la figure 6.

Selon la figure 9, une dernière étape d'assemblage du dispositif optique 10 comprend l'insertion du boîtier de protection 12. L'insertion du boîtier de protection 12 se fait également avec le support de lentilles 14 renversé de sorte que son extrémité haute 19 soit toujours en appui sur le socle 60. Le boîtier de protection 12 st inséré suivant la direction vertical D vers le bas jusqu'à ce que son extrémité basse 18 vienne en buté contre la plaque de butée 16 du support de lentilles 14. C'est lors de cette étape que la partie principale rigide 34 de la carte à circuit imprimé 32 vient s'agencer dans le fond de boîtier 26 de sorte que les terminaux électriques 40 vienne s'insérer dans le corps du connecteur 28 du boitier de protection 12.

De façon alternative aux étapes de pliage et d'insertion du collier de serrage 52 autour des parties flexibles 42, 44, 46, 48, le collier de serrage 52 peut-être substitué par la paroi 15 du boitier de protection 12. Selon cette alternative, l'extrémité haute 18 du boitier de protection 12 est préalablement agencée sur les parties flexibles 42, 44, 46, 48 lorsque celles-ci s'étendent encore globalement dans le plan de la partie principale rigide 34 comme illustré sur la figure 6. C'est l'insertion du boitier de protection 12 suivant la direction verticale D qui provoque le pliage des parties flexibles 42, 44, 46, 48, les partie flexibles 42, 44, 46, 48 pouvant ensuite être maintenues en appui contre la paroi 31 du support de lentilles 14 par la paroi 15 du boitier de protection 12.

Afin d'éviter un endommagement des parties flexibles 42, 44, 46, 48, lorsque la paroi 15 du boîtier de protection 12 permet le pliage des parties flexibles 42, 44, 46, 48 et le maintien des parties flexibles 42, 44, 46, 48 en appui contre la paroi 31 du support de lentilles 14, l'extrémité haute 18 de la paroi 15 du boîtier de protection 12 comprend des arêtes en pente inclinée, chaque arrête formant un chanfrein orienté vers la surface interne de la paroi 45 du boîtier de protection 12. Chaque arête en pente inclinée est agencée dans l'alignement vertical de chaque partie flexible 42, 44, 46, 48 de sorte, par exemple, à éviter un cisaillement des parties flexibles 42, 44, 46, 48 lors de cette étape d'assemblage.

## Revendications

1. Dispositif optique (10) comprenant
une carte à circuit imprimé (32) comprenant une partie principale rigide (34) et comprenant au moins une partie flexible (42) agencée en périphérie de la partie principale rigide (34), la partie principale rigide (34) comportant un circuit électronique de capture d'image(36);
un support de lentilles (14) comprenant au moins une lentille optique (22), le support de lentilles (14) comprenant une paroi (31) formant une cavité (21) s'étendant selon l'axe optique (O) du dispositif (10) depuis son extrémité haute (19) jusqu'à son extrémité basse (30), l'extrémité basse (30) étant montée sur la partie principale rigide (34) de la carte à circuit imprimé (32) de sorte à aligner, selon l'axe optique (O) du dispositif (10), le circuit électronique de capture d'images (36) et la lentille optique (22); et
au moins un élément de chauffage (50) est agencé sur la partie flexible (42) de la carte à circuit imprimé (32), la partie flexible (42) de la carte à circuit imprimé (32) étant agencée en appui direct contre la paroi (31) du support de lentilles (14),
**caractérisé en ce que** l'extrémité haute (19) de la paroi du support de lentilles (14) comprend un rebord (68) orienté vers l'extérieur de la paroi (31) du support de lentilles (14) formant une surface plane d'appui, la partie flexible (42) de la carte à circuit imprimé (32) étant agencée en appui uniquement contre la surface plane d'appui de la paroi (31).

2. Dispositif optique (10) selon la revendication 1, **caractérisé en ce que** l'élément de chauffage (50) est agencé en appui direct sur la surface plane d'appui de la paroi (31).

3. Dispositif optique (10) selon l'une quelconque des revendications précédentes, **caractérisé en ce qu'**un collier métallique (52) de serrage est agencé autour de la paroi (31) du support de lentilles (14) de sorte que chaque partie flexible (42, 44, 46, 48) de la carte à circuit imprimé (32) est pincée entre le collier (52) métallique et la surface plane d'appui de la paroi (31) du support de lentilles (14).

4. Dispositif optique (10) selon l'une quelconque des revendications 1 à 2, **caractérisé en ce que** chaque partie flexible (42, 44, 46, 48) de la carte à circuit imprimé (32) est pincée entre la surface plane d'appui de la paroi (31) du support de lentilles (14) et une paroi cylindrique d'un boîtier de protection (12) du dispositif optique (10).

5. Dispositif optique (10) selon l'une quelconque des revendications précédentes, **caractérisé en ce que** l'élément de chauffage (50) comprend un motif de trace conductrice d'une partie flexible (42) de la carte à circuit imprimé (32).

6. Dispositif optique (10) selon l'une quelconque des revendications précédentes, **caractérisé en ce que** la partie flexible (42) de la carte à circuit imprimé (32) comprend une section de chauffage (54) et une section intermédiaire (64) comprise entre la section de chauffage (54) et la partie principale rigide (34) de la carte à circuit imprimé (32), la section intermédiaire (64) comprenant une partie amincie du substrat de la partie principale rigide (34) de la carte à circuit imprimé (32), la section de chauffage (54) comprenant l'élément de chauffage (50).

7. Dispositif optique (10) selon l'une quelconque des revendications précédentes, **caractérisé en ce que** chaque côté de la partie principale rigide (34) de la carte à circuit imprimé (34) est en continuité avec une partie flexible (42, 44, 46, 48) comportant chacune un élément de chauffage (50).

8. Méthode d'assemblage d'un dispositif optique (10) selon l'une quelconque des revendications précédentes, **caractérisée en ce qu'**elle comporte les étapes suivantes :
fourniture d'une carte à circuit imprimé (32) comprenant une partie principale rigide (34) comportant un composant électronique de capture d'image (36), et au moins une partie flexible (42) comportant un élément de chauffage (50) et s'étendant globalement dans le plan de la partie principale rigide (34);
agencement de la partie principale rigide (34) de la carte à circuit imprimé (32) sur un support de lentilles (14) comportant au moins une lentille optique (22) et comprenant une paroi formant une cavité (21) s'étendant selon l'axe optique du dispositif (O) de sorte à aligner, selon l'axe optique (O) du dispositif (10), le circuit électronique de capture d'images (36) et la lentille optique (22);
pliage de la partie flexible (42) de la carte à circuit imprimé (32) jusqu'à la mise en buté de la partie flexible (42) sur une surface plane d'appui de la paroi (31) du support de lentilles (14), cette surface place d'appui étant formée par un rebord (68) de l'extrémité haute (19) de la paroi du support de lentilles (14), ledit rebord (68) étant orienté vers l'extérieur de la paroi (31) du support de lentilles (14) ;
fixation de la partie flexible (42) de la carte à circuit imprimé (32) en appui contre la surface plane d'appui de la paroi (31) du support de lentilles (14).

9. Méthode d'assemblage d'un dispositif optique (10) selon la revendication précédente **caractérisé en ce que**
l'étape de pliage et l'étape de fixation se font soit par insertion du support de lentilles (14) dans un boîtier de protection (12) du dispositif optique (10) de sorte à venir pincer la partie flexible (42) entre la paroi (15) du boîtier (12) de protection (12) et la paroi (31) du support de lentilles (14), ou soit par insertion d'un collier de serrage (52) autour de la surface plane d'appui de la paroi (31) du support de lentilles (14) et de la partie flexible (42) de sorte à venir pincer la partie flexible (42) entre le collier de serrage (52) et la surface plane d'appui de la paroi (31) du support de lentilles (14).

## Patentansprüche

1. Optische Vorrichtung (10) umfassend
eine Leiterplatte (32) mit einem starren Hauptteil (34) und mit mindestens einem flexiblen Teil (42), der am Umfang des starren Hauptteils (34) angeordnet ist, wobei der starre Hauptteil (34) eine elektronische Schaltung zur Bilderfassung (36) enthält;
einen Linsenhalter (14) mit mindestens einer optischen Linse (22), wobei der Linsenhalter (14) eine Wand (31) aufweist, die einen Hohlraum (21) bildet, der sich entlang der optischen Achse (0) der Vorrichtung (10) von ihrem oberen Ende (19) bis zu ihrem unteren Ende (30) erstreckt, wobei das untere Ende (30) an dem starren Hauptteil (34) der Leiterplatte (32) so angebracht ist, dass es die elektronische Schaltung zur Bilderfassung (36) und die optische Linse (22) entlang der optischen Achse (0) der Vorrichtung (10) ausrichtet; und
mindestens ein Heizelement (50), das an dem flexiblen Teil (42) der Leiterplatte (32) angeordnet ist, wobei der flexible Teil (42) der Leiterplatte (32) direkt anliegend an der Wand (31) des Linsenhalters (14) angeordnet ist,
**dadurch gekennzeichnet, dass** das obere Ende (19) der Wand des Linsenhalters (14) einen Rand (68) umfasst, der zur Außenseite der Wand (31) des Linsenhalters (14) hin gerichtet ist und eine ebene Auflagefläche bildet, wobei der flexible Teil (42) der Leiterplatte (32) so angeordnet ist, dass er nur an der ebenen Auflagefläche der Wand (31) anliegt.

2. Optische Vorrichtung (10) nach Anspruch 1, **dadurch gekennzeichnet, dass** das Heizelement (50) direkt anliegend an der ebenen Auflagefläche der Wand (31) angeordnet ist.

3. Optische Vorrichtung (10) nach einem der vorstehenden Ansprüche, **dadurch gekennzeichnet, dass** ein metallischer Klemmring (52) um die Wand (31) des Linsenhalters (14) herum angeordnet ist, so dass jeder flexible Teil (42, 44, 46, 48) der Leiterplatte (32) zwischen dem metallischen Klemmring (52) und der ebenen Auflagefläche der Wand (31) des Linsenhalters (14) eingeklemmt ist.

4. Optische Vorrichtung (10) nach einem der Ansprüche 1 bis 2, **dadurch gekennzeichnet, dass** jeder flexible Teil (42, 44, 46, 48) der Leiterplatte (32) zwischen der ebenen Auflagefläche der Wand (31) des Linsenhalters (14) und einer zylindrischen Wand eines Schutzgehäuses (12) der optischen Vorrichtung (10) eingeklemmt ist.

5. Optische Vorrichtung (10) nach einem der vorstehenden Ansprüche, **dadurch gekennzeichnet, dass** das Heizelement (50) ein Leiterbahnmuster eines flexiblen Teils Abschnitts (42) der Leiterplatte (32) umfasst.

6. Optische Vorrichtung (10) nach einem der vorstehenden Ansprüche, **dadurch gekennzeichnet, dass** der flexible Teil (42) der Leiterplatte (32) einen Heizabschnitt (54) und einen Zwischenabschnitt (64) umfasst, der zwischen dem Heizabschnitt (54) und dem starren Hauptteil (34) der Leiterplatte (32) liegt, wobei der Zwischenabschnitt (64) einen verdünnten Teil des Substrats des starren Hauptteils (34) der Leiterplatte (32) umfasst und der Heizabschnitt (54) das Heizelement (50) umfasst.

7. Optische Vorrichtung (10) nach einem der vorstehenden Ansprüche, **dadurch gekennzeichnet, dass** jede Seite des starren Hauptteils (34) der Leiterplatte (32) in einen flexiblen Teil (42, 44, 46, 48) übergeht, der jeweils ein Heizelement (50) aufweist.

8. Verfahren zum Zusammenbau einer optischen Vorrichtung (10) nach einem der vorstehenden Ansprüche, **dadurch gekennzeichnet, dass** es die folgenden Schritte umfasst:
Bereitstellen einer Leiterplatte (32) mit einem starren Hauptteil (34), der eine elektronische Bilderfassungskomponente (36) enthält, und mindestens einem flexiblen Teil (42), der ein Heizelement (50) enthält und sich im Allgemeinen in der Ebene des starren Hauptteils (34) erstreckt;
Anordnen des starren Hauptteils (34) der Leiterplatte (32) auf einem Linsenhalter (14), der mindestens eine optische Linse (22) aufweist und eine Wand umfasst, die einen Hohlraum (21) bildet, der sich entlang der optischen Achse der Vorrichtung (0) erstreckt, um die elektronische Schaltung zur Bilderfassung (36) und die optische Linse (22) entlang der optischen Achse (0) der Vorrichtung (10) auszurichten;
Falten des flexiblen Teils (42) der Leiterplatte (32), bis der flexible Teil (42) an einer ebenen Auflagefläche der Wand (31) des Linsenhalters (14) anliegt, wobei diese Auflagefläche durch einen Rand (68) des oberen Endes (19) der Wand des Linsenhalters (14) gebildet wird, wobei der Rand (68) zur Außenseite der Wand (31) des Linsenhalters (14) hin gerichtet ist;
Befestigen des flexiblen Teils (42) der Leiterplatte (32) anliegend an der ebenen Auflagefläche der Wand (31) des Linsenhalters (14).

9. Verfahren zum Zusammenbau einer optischen Vorrichtung (10) nach dem vorstehenden Anspruch, **dadurch gekennzeichnet, dass**
der Schritt des Faltens und der Schritt des Befestigens entweder durch Einsetzen des Linsenhalters (14) in ein Schutzgehäuse (12) der optischen Vorrichtung (10) erfolgt, so dass der flexible Teil (42) zwischen der Wand (15) des Schutzgehäuses (12) und der Wand (31) des Linsenhalters (14) eingeklemmt wird, oder durch Einsetzen eines Klemmrings (52) um die ebene Auflagefläche der Wand (31) des Linsenhalters (14) und des flexiblen Teils (42) herum, so dass der flexible Teil (42) zwischen dem Klemmring (52) und der ebenen Auflagefläche der Wand (31) des Linsenhalters (14) eingeklemmt wird.

## Claims

1. An optical device (10) comprising
a printed circuit board (32) comprising a rigid main part (34) and comprising at least one flexible part (42) arranged on the circumference of the rigid main part (34), the rigid main part (34) including an image-capturing circuit (36);
a lens holder (14) comprising at least one optical lens (22), the lens holder (14) comprising a wall (31) forming a cavity (21) extending along the optical axis (O) of the device (10) from its top end (19) to its bottom end (30), the bottom end (30) being mounted on the rigid main part (34) of the printed circuit board (32) such as to align, along the optical axis (O) of the device (10), the electronic image-capturing circuit (36) and the optical lens (22); and
at least one heating element (50) is arranged on the flexible part (42) of the printed circuit board (32), the flexible part (42) of the printed circuit board (32) being arranged directly bearing against the wall (31) of the lens holder (14),
**characterized in that** the top end (19) of the wall of the lens holder (14) comprises a border (68) oriented toward the outside of the wall (31) of the lens holder (14) forming a flat bearing surface, the flexible part (42) of the printed circuit board (32) being arranged bearing solely against the flat bearing surface of the wall (31).

2. The optical device (10) as claimed in claim 1, **characterized in that** the heating element (50) is arranged directly bearing on the flat bearing surface of the wall (31).

3. The optical device (10) as claimed in any of the preceding claims, **characterized in that** a metal clamping ring (52) is arranged around the wall (31) of the lens holder (14) such that each flexible part (42, 44, 46, 48) of the printed circuit board (32) is caught between the metal ring (52) and the flat bearing surface of the wall (31) of the lens holder (14) .

4. The optical device (10) as claimed in any of claims 1 to 2, **characterized in that** each flexible part (42, 44, 46, 48) of the printed circuit board (32) is caught between the flat bearing surface of the wall (31) of the lens holder (14) and a cylindrical wall of a protective casing (12) of the optical device (10).

5. The optical device (10) as claimed in any of the preceding claims, **characterized in that** the heating element (50) comprises a conductive trace pattern of a flexible part (42) of the printed circuit board (32).

6. The optical device (10) as claimed in any of the preceding claims, **characterized in that** the flexible part (42) of the printed circuit board (32) comprises a heating section (54) and an intermediate section (64) between the heating section (54) and the rigid main part (34) of the printed circuit board (32), the intermediate section (64) comprising a thinned part of the substrate of the rigid main part (34) of the printed circuit board (32), the heating section (54) comprising the heating element (50).

7. The optical device (10) as claimed in any of the preceding claims, **characterized in that** each side of the rigid main part (34) of the printed circuit board (32) is in continuity with a flexible part (42, 44, 46, 48) each including a heating element (50).

8. A method for assembling an optical device (10) as claimed in any of the preceding claims, **characterized in that** it includes the following steps:
supplying a printed circuit board (32) comprising a rigid main part (34) including an electronic image-capturing component (36), and at least one flexible part (42) including a heating element (50) and extending globally in the plane of the rigid main part (34);
arranging the rigid main part (34) of the printed circuit board (32) on a lens holder (14) including at least one optical lens (22) and comprising a wall forming a cavity (21) extending along the optical axis (O) of the device such as to align, along the optical axis (O) of the device (10), the electronic image-capturing circuit (36) and the optical lens (22);
folding the flexible part (42) of the printed circuit board (32) up to the abutment of the flexible part (42) on a flat bearing surface of the wall (31) of the lens holder (14), this flat bearing surface being formed by a border (68) of the top end (19) of the wall of the lens holder (14), said border (68) being oriented toward the outside of the wall (31) of the lens holder (14);
attaching the flexible part (42) of the printed circuit board (32) bearing against the flat bearing surface of the wall (31) of the lens holder (14).

9. A method for assembling an optical device (10) as claimed in the preceding claim **characterized in that**
the folding step and the attaching step are done either by inserting the lens holder (14) into a protective casing (12) of the optical device (10) such as to catch the flexible part (42) between the wall (15) of the protective casing (12) and the wall (31) of the lens holder (14), or either by inserting a clamping ring (52) around the flat bearing surface of the wall (31) of the lens holder (14) and
of the flexible part (42) such as to then catch the flexible part (42) between the clamping ring (52) and the flat bearing surface of the wall (31) of the lens holder (14).
